# EUROPÄISCHE PATENTANMELDUNG

(11) **EP 3 904 071 A2**
(43) Veröffentlichungstag der Anmeldung: **03.11.2021**
(21) Anmeldenummer: 21167344.7
(22) Anmeldetag: 08.04.2021
(51) Int. Cl.: B32B 7/025, B32B 5/02, B32B 5/26, B32B 15/02

(54) **FLÄCHENELEMENT**

(30) Priorität: 28.04.2020 DE 102020111547
(71) Anmelder: Haas, Stefan, 84181 Neufraunhofen (DE)
(72) Erfinder: HAAS, Stefan, 84181 Neufraunhofen (DE); SCHUMACHER, Rolf, 72336 Balingen (DE)
(74) Vertreter: Ruckh, Rainer Gerhard

(57) **Zusammenfassung**

Die Erfindung betrifft ein Flächenelement (1) mit einer ersten Schicht (2), welche eine in einem isolierenden Material eingebettete Leiterschleife (3) aufweist, und mit einer eine Sensorschicht (5) ausbildenden zweiten Schicht, die in Kontakt mit der Leiterschleife (3) ist. Die Sensorschicht (5) ist zur Erfassung wenigstens einer externen Einflussgröße ausgebildet. Abhängig von dieser Erfassung ist ein in der Leiterschleife (3) fließender Strom beeinflusst. Das Flächenelement (1) kann in einem Umkehrbetrieb derart betrieben werden, dass durch Einspeisen von Strömen in die Leiterschleife (3) die oder jede Sensorschicht (5) Ausgangsgrößen generiert.

## Beschreibung

Die Erfindung betrifft ein Flächenelement.

Derartige Flächenelemente können beispielsweise als textile Flächen ausgebildet sein. Diese textile Flächen können mit leitfähigen Fäden versehen sein, mittels derer Sensorfunktionen bereitgestellt werden.

Aus der WO 2018/113993 A1 ist ein Verfahren bekannt, bei welchem Sensorstrukturen und Schnittfeststrukturen bei einem Flächenelement mittels einer Kettenwirkmaschine oder Raschelmaschine hergestellt werden. Sensorfäden als Sensorstrukturen und schnittfeste Fäden als Schnittfeststrukturen sind auf derselben Seite des Flächenelements eingearbeitet. Die Sensorfäden sind dahingehend optimiert, damit mit diesen gut nachweisbare elektrische Signale generiert werden, welche in einer Messvorrichtung auswertbar sind, um im Fall einer Unterbrechung der Sensorfäden eine Alarmmeldung oder dergleichen generieren zu können.

Der Erfindung liegt die Aufgabe zugrunde ein Flächenelement mit erweiterter Funktionalität bereitzustellen.

Zur Lösung dieser Aufgabe sind die Merkmale des Anspruchs 1 vorgesehen. Vorteilhafte Ausführungsformen und zweckmäßige Weiterbildungen der Erfindung sind in den abhängigen Ansprüchen beschrieben.

Die Erfindung betrifft ein Flächenelement mit einer ersten Schicht, welche eine in einem isolierenden Material eingebettete Leiterschleife aufweist, und mit einer eine Sensorschicht ausbildenden zweiten Schicht, die in Kontakt mit der Leiterschleife ist. Die Sensorschicht ist zur Erfassung wenigstens einer externen Einflussgröße ausgebildet. Abhängig von dieser Erfassung ist ein in der Leiterschleife fließender Strom beeinflusst. Das Flächenelement kann in einem Umkehrbetrieb derart betrieben werden, dass durch Einspeisen von Strömen in die Leiterschleife die oder jede Sensorschicht Ausgangsgrößen generiert.

Der Grundgedanke der Erfindung besteht somit darin, mit der Sensorschicht ein flächiges, vorzugsweise sich über die gesamte Fläche des Flächenelements erstreckendes Sensorelement auszubilden, mittels dessen gemäß der ersten Variante der Erfindung mit hoher Empfindlichkeit externe Einflussgrößen registriert werden können.

Gemäß einer weiteren Alternative können mit der Sensorschicht gezielt Ausgangsgrößen generiert werden, wenn das Flächenelement in einem Umkehrbetrieb betrieben wird.

Die externen Einflussgrößen bewirken Änderungen von Zustandsgrößen der Sensorschicht, die zu einer Änderung des Stroms (das heißt generell des elektrischen Stroms) in der Leiterschleife führen, da die Leiterschleife in Kontakt mit der Sensorschicht ist.

Durch eine zeitaufgelöste Auswertung des Stroms in der Leiterschleife können nicht nur Zeitabhängigkeiten einer externen Einflussgröße ermittelt werden. Vielmehr können dadurch auch zwei oder noch mehr externe Einflussgrößen, die simultan mit der Sensorschicht erfasst werden, voneinander unterschieden werden, wenn diese ein hinreichend unterschiedliches Zeitverhalten aufweisen.

Dies ist beispielsweise dann der Fall, wenn die Sensorschicht eine leitfähige Schicht ist. Die leitfähige Schicht ist zur Erfassung mechanischer Belastungen und/oder zur Erfassung von Umgebungs-Feuchtigkeit ausgebildet.

Während mechanische Belastungen zu kurzzeitigen Änderungen des Stroms in der Leiterschleife führen, bewirkt der Einfluss von Umgebungsfeuchtigkeit eine nahezu zeitlich konstante Änderung des Stroms in der Leiterschleife. Durch eine zeitaufgelöste Auswertung des Stroms in der Leiterschleife können beide Einflussgrößen separat erfasst werden. Abhängig vom Anwendungsfall können die zeitaufgelösten Auswertungen einer Einflussgröße zugeordnet werden. Beispielsweise bilden mechanische Belastungen langfristig ändernde Einflussgrößen, Feuchtigkeit dagegen eine sich kurzzeitig ändernde Einflussgröße.

Alternativ kann die Sensorschicht eine piezoelektrische Schicht sein. Die piezoelektrische Schicht ist zur Erfassung mechanischer Belastungen ausgebildet.

Somit wird in diesem Fall nur eine externe Einflussgröße durch Auswerten des Stroms der Leiterschleife erfasst.

Vorteilhaft können beide Seiten des Flächenelements mit einer Isolationsschicht abgedeckt sein, wodurch ein Schutz der Sensorstrukturen bereitgestellt wird.

Generell kann die erste und zweite Schicht von einem gemeinsamen Flächensegment oder von zwei separaten Flächensegmenten gebildet sein.

Beispielsweise kann ein einziges Flächensegment in Form einer Folie oder dergleichen vorgesehen sein, in welcher sowohl die Leiterschleife als auch die Sensorschicht integriert sein können.

Für den Fall, dass die erste und zweite Schicht separate Flächensegmente ausbilden, ist vorteilhaft, dass die erste Schicht eine textile Fläche ist, wobei die Leiterschleife an der der Sensorschicht zugewandten Seite der ersten Schicht vorgesehen ist.

Beispielsweise ist die textile Fläche ein Gewebe, Gestrick, Gewirke oder ein Vlies.

Vorteilhaft ist dann, dass die Leiterschleife in Form von elektrisch leitfähigen Fäden in die textile Fläche eingearbeitet ist.

Dabei kann das Einarbeiten mittels geeigneter Textilmaschinen, mit der Web-, Wirk-, Strickvorgänge oder dergleichen durchgeführt werden, erfolgen.

Auch andere Verfahren wie zum Beispiel Bedruckungsverfahren können zur Herstellung der Leiterschleife eingesetzt werden.

Vorteilhaft ist die Sensorschicht als Beschichtung auf die erste Schicht aufgebracht.

Gemäß einer vorteilhaften Weiterbildung ist an der zur Sensorschicht gegenüberliegenden Seite der ersten Schicht eine Adaptionsschicht vorgesehen.

Dabei besteht die Adaptionsschicht aus einem isolierenden oder schwach leitfähigen Material.

Die Adaptionsschicht bildet insbesondere eine applikationsspezifische Anpassung an unterschiedliche Medien, auf welche das Flächenelement aufgebracht wird, aus.

Gemäß einer vorteilhaften alternativen Weiterbildung der Erfindung ist an gegenüberliegenden Seiten der ersten Schicht jeweils eine Leiterschleife vorgesehen, wobei jede Leiterschleife in Kontakt mit einer Sensorschicht ist.

Damit stehen zwei Sensorschichten zur Verfügung, mittels derer vorteilhaft unterschiedliche externe Einflussgrößen erfasst werden können. Hierbei besteht ein weiterer wesentlicher Vorteil darin, dass jeder Sensorschicht eine separate Leiterschleife zugeordnet ist, sodass mit diesen die externen Einflussgrößen separat und unabhängig voneinander erfasst werden können.

Gemäß einer alternativen Ausgestaltung der Erfindung ist die Sensorschicht in der Leiterschleife integriert.

Beispielsweise ist die Leiterschleife in Form von elektrisch leitfähigen Fäden gebildet, welche mit Sensorfäden Umwindungen ausbilden, wobei die Sensorfäden die Sensorschicht ausbilden.

Dadurch, dass sich die leitfähigen Fäden und Sensorfäden umwinden, sind diese miteinander mechanisch in Kontakt.

Damit können durch externe Einflussgrößen bedingte Änderungen der Sensorfäden direkt auf die die Leiterschleife bildenden elektrisch leitfähigen Fäden übertragen werden, wodurch sich der Strom in der Leiterschleife ändert und damit die externe Einflussgröße messtechnisch erfasst wird.

Beispielsweise sind die Sensorfäden von piezoelektrischen Fäden gebildet.

Mit diesen Sensorfäden werden mechanische Belastungen, die auf das Flächenelement einwirken, erfasst.

Besonders vorteilhaft kann als Sensorschicht ein Netz von piezoelektrischen Fäden vorgesehen sein, auf welches eine Leiterschleife integriert wird.

Generell bilden die Ausgangssignale der oder jeder Leiterschleife ein Maß für externe Einflussgrößen.

Die erfindungsgemäßen Flächenelemente können in unterschiedlichen Applikationen eingesetzt werden.

Insbesondere können die Flächenelemente in Böden oder Wänden von Gebäuden verlegt werden. Insbesondere kann in Bädern eine fortlaufende Feuchtigkeitskontrolle erfolgen. Dabei können die Flächenelemente Umhüllungen von Leitungen oder Rohren, in denen Flüssigkeiten wie Öl, Wasser oder toxische Stoffe transportiert werden, bilden. Mit dem Flächenelement kann ein unkontrollierter Flüssigkeitsaustritt detektiert werden. Auch können durch Flächenelemente auf Böden mechanische Belastungen erfasst werden. Weitere Anwendungen sind Gewichtsbestimmungen von Paletten, Containern und dergleichen. Auch können Aufprallwirkungen von Geschossen auf Schutzwesten, die mit dem Flächenelement ausgerüstet sind, analysiert werden.

Auch Outdooranwendungen, wie zum Beispiel auf Terrassen oder Balkonen von Gebäuden sind möglich.

Schließlich sind auch Anwendungen in Kraftfahrzeugen, beispielsweise auf Ladeflächen von Lastkraftwagen möglich.

Gemäß der zweiten Variante der Erfindung kann das erfindungsgemäße Flächenelement auch in einem Umkehrbetrieb derart betrieben sein, dass durch Einspeisen von Strömen in die Leiterschleife die oder jede Sensorschicht Ausgangsgrößen generiert.

Beispielsweise sind als Ausgangsgrößen Lichtabstrahlungen oder eine Wärmeabgabe vorgesehen.

Gemäß einer besonders vorteilhaften Ausgestaltung weist das Flächenelement zwei erste Schichten mit jeweils einer in einem isolierenden Material eingebetteten Leiterschleife auf. Zwischen den ersten Schichten ist eine Sensorschicht vorgesehen, die im Umkehrbetrieb des Flächenelements Ausgangsgrößen generieren kann.

Eine vorteilhafte Ausführung ist dabei die Erzeugung von elektrischen Feldern, wenn die Leiterschleifen so ausgelegt sind, dass zwei entgegengesetzt geladene Schichten entstehen.

Auch magnetische Felder können durch das Flächenelement im Umkehrbetrieb erzeugt werden.

Die Sensorschicht kann durch Anlegen einer Spannung elektrochemische Prozesse beeinflussen, Externe Einflussgrößen, die Bestandteil dieser Prozesse sind, können sowohl von außen zugetragen werden, als auch in der Sensorschicht gespeichert werden.

In einem ersten Anwendungsfall kann damit das Flächenelement eine selbstdesinfizierende Wirkung aufweisen. Das Flächenelement kann dann beispielsweise als Schutzmaske eingesetzt werden. Auch können insbesondere im öffentlichen Bereich eingesetzte Gebrauchsgegenstände an ihren Oberflächen mit dem Flächenelement verkleidet sein, das durch seine selbstdesinfizierende Wirkung selbstreinigend ist. Beispiele hierfür sind Parkbänke oder dergleichen.

Damit entfalten aufwändige Reinigungs- und/oder Desinfektionsvorgänge für diese Gegenstände.

Derartige mit den erfindungsgemäßen Flächenelementen versehene Gegenstände können vorteilhaft für Einsatzbereiche genutzt werden, in denen Personen häufig in Kontakt mit den Gegenständen kommen.

Beispiele für derartige Einsatzbereiche sind öffentliche Gebäude und Anlagen, Krankenhäuser, öffentliche Verkehrsmittel, Hotels und Büros.

Gegenstände, die mit den erfindungsgemäßen Flächenelementen versehen werden, können Türgriffe, Türrahmen, Wände oder auch Gebrauchsgegenstände wie Tabletts, Wägen oder Sitzüberzüge sein. Auch können Bekleidungen mit den Flächenelementen versehen werden, insbesondere Polizei-, Sanitäts- oder Militärbekleidung.

Die Funktionsweise des Flächenelements ist dann derart, dass die Sensorschicht eine elektrisch isolierende Schicht bzw. Membran ist, in welcher bei einer an den Leiterschleifen anliegender Spannung reaktive Sauerstoffverbindungen generiert werden.

Die ersten Schichten können analog zur Ausbildung des Flächenelements gemäß der ersten Variante der Erfindung ausgebildet sein. Insbesondere können die ersten Schichten als textile Flächen ausgebildet sein. Die Leiterschleifen können in Form von elektrisch leitfähigen Fäden in die textilen Flächen eingearbeitet sein. Alternativ können die Leiterschleifen als Bedruckungen oder Beschichtungen ausgebildet sein.

Die elektrisch isolierende Sensorschicht kann in Form einer Folie, Beschichtung oder dergleichen ausgebildet sein. Besonders vorteilhaft besteht die Sensorschicht aus einem Vlies oder einer ähnlichen textilen Fläche. Vorteilhaft bildet die Sensorschicht eine poröse, elektroosmotische Schicht. Zusammen mit Wasser, Feuchtigkeit beziehungsweise Sauerstoff werden bei Anlegen einer Spannung an die Leiterschleifen reaktive Sauerstoffverbindungen, sogenannte ROS (reactive oxygen species) generiert, die Krankheitserreger wie Viren oder Bakterien schädigen können. Ein Beispiel für ein ROS ist Sauerstoffperoxid.

Ein weiterer Anwendungsfall kann dadurch gegeben sein, dass die Sensorschicht eine elektrisch isolierende Schicht ist, in welcher abhängig vom Anliegen einer Spannung an der Leiterschleife als Ausgangsgröße eine Ionenstruktur durch die Kraftauswirkungen aus der Sensorschicht geändert wird. Dabei ist je nach Zustand der Ausgangsgröße die Sensorschicht luftdurchlässig oder luftundurchlässig.

Bei beiden Varianten des erfindungsgemäßen Flächenelements kann dieses an beiden Seiten mit einer isolierenden Schicht abgedeckt sein.

Um besonders großflächige Strukturen zu realisieren, kann eine Mehrfachanordnung mit mehreren aneinander anschließenden Flächenelementen vorgesehen sein, wobei dann die Leiterschleifen der einzelnen Flächenelemente miteinander leitend verbunden sind.

Die Erfindung wird im Folgenden anhand der Zeichnungen erläutert. Es zeigen:
- Figur 1:: Erstes Ausführungsbeispiel des erfindungsgemäßen Flächenelements.
- Figur 2:: Einzeldarstellung von Komponenten des Flächenelements gemäß Figur 1.
- Figur 3:: Zweites Ausführungseispiel des erfindungsgemäßen Flächenelements.
- Figur 4:: Einzeldarstellung von Komponenten des Flächenelements gemäß Figur 3.
- Figur 5:: Weiteres Ausführungsbeispiel des erfindungsgemäßen Flächenelements.

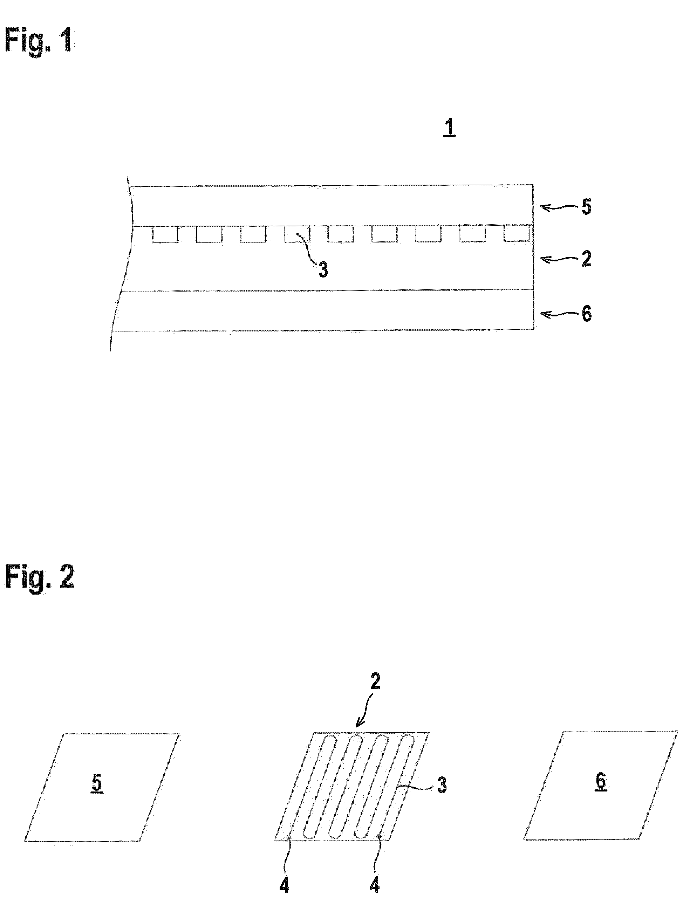

Figur 1 zeigt ein erstes Ausführungsbeispiel des erfindungsgemäßen Flächenelements 1, wobei dessen Komponenten in Figur 2 in Einzeldarstellungen dargestellt sind.

Das Flächenelement 1 gemäß den Figuren 1 und 2 weist eine erste Schicht 2 auf, die allgemein aus einem isolierenden, das heißt nicht leitfähigen Material besteht, wobei in dieser Schicht eine aus einem elektrisch leitfähigen Material bestehende Leiterschleife 3 vorgesehen ist.

Die erste Schicht 2 besteht im vorliegenden Fall aus einer textilen Fläche, die aus isolierenden Fäden beziehungsweise Garnen aufgebaut ist.

Beispielsweise ist die textile Fläche ein Gewebe, Gestrick, Gewirke oder ein Vlies.

Im vorliegenden Fall ist die Leiterschleife 3 in Form von elektrisch leitfähigen Fäden in die textile Fläche eingearbeitet.

Wie aus Figur 2 ersichtlich erstreckt sich die Leiterschleife 3 über die gesamte Oberfläche der ersten Schicht 2, wobei die Schleife mäanderförmig in mehreren Schlaufen verläuft.

An einem Rand der ersten Schicht 2 münden die freien Enden der Leiterschleife 3 aus, die Messpunkte 4 ausbilden, an welchen ein Messgerät, insbesondere ein Strommessgerät angeschlossen werden kann.

Im vorliegenden Fall münden die Messpunkte 4 an demselben Rand der ersten Schicht 2 aus. Generell können die beiden Messpunkte 4 an unterschiedlichen Rändern, insbesondere an gegenüberliegenden Rändern ausmünden.

Die zweite Schicht bildet eine Sensorschicht 5, mittels derer eine oder mehrere externe Einflussgrößen erfasst werden können. Dabei bildet bevorzugt die gesamte Oberfläche der Sensorschicht 5 eine für die Erfassung der Einflussgrößen empfindliche Fläche.

Die Sensorschicht 5 ist im vorliegenden Fall in Form einer Beschichtung ausgebildet, die auf die erste Schicht 2 aufgebracht ist. Prinzipiell könnten die erste und zweite Schicht auch ein gemeinsames Flächensegment, beispielsweise in Form einer Folie bilden.

Die Sensoreinheit kann von einer piezoelektrischen Schicht gebildet sein.

Im vorliegenden Fall ist die Sensorschicht 5 in Form einer elektrisch leitfähigen Schicht ausgebildet. Wesentlich ist, dass, wie aus Figur 1 ersichtlich, die leitfähige Schicht, das heißt die Sensorschicht 5, in Kontakt mit der Leiterschleife 3 der ersten Schicht 2 ist.

Damit wirken sich Änderungen der (elektrischen) Leitfähigkeit direkt auf den Strom in der Leiterschleife 3 aus, was durch Messungen an den Messpunkten 4 sofort registriert wird.

Mit der leitfähigen Sensorschicht 5 können zwei externe Einflussgrößen erfasst werden, nämlich einerseits die Leitfähigkeit beeinflussende Umgebungsfeuchtigkeit und andererseits mechanische Belastungen, die lokal zu Verformungen der Sensorschicht 5 führen und dadurch bedingt zu Stromänderungen in der Leiterschleife 3.

Die beiden Einflussgrößen können in einer geeigneten Auswerteeinheit getrennt dadurch erfasst werden, dass eine zeitaufgelöste Erfassung des Stroms in der Leiterschleife 3 erfolgt. Dadurch können statische Änderungen des Stroms in der Leiterschleife 3, die durch die Umgebungsfeuchtigkeit bedingt sind, sicher von dynamischen zeitlich stärker variierenden Stromänderungen in der Leiterschleife 3 bedingt durch mechanische Einflüsse unterschieden werden. Die Zuordnung der Stromänderung kann je nach Anwendungsfall variieren.

Die dritte Schicht des Flächenelements 1 gemäß Figur 1 bildet eine Adaptionsschicht 6, die insbesondere für eine Anpassung des Flächenelements 1 an unterschiedliche Untergrundmaterialien ausgebildet ist.

Vorteilhaft besteht die Adaptionsschicht 6 aus einem isolierenden oder schwach leitfähigen Material.

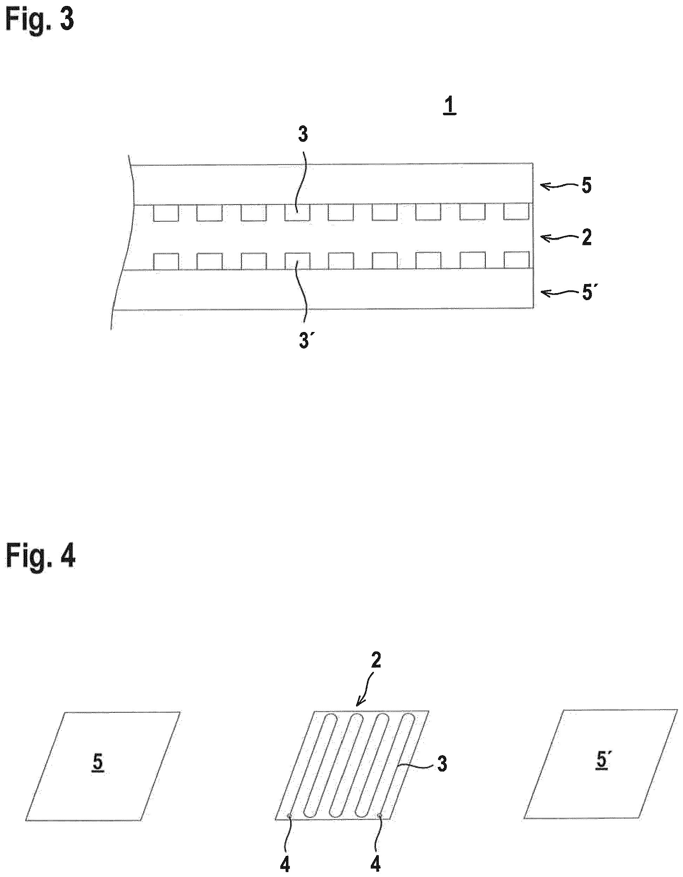

Figur 3 zeigt ein zweites Ausführungsbeispiel des erfindungsgemäßen Flächenelements 1.

Bei der Ausführungsform gemäß Figur 3 ist an gegenüberliegenden Seiten der ersten Schicht 2 jeweils eine Sensorschicht 5, 5' vorgesehen.

In der ersten Schicht 2 befindet sich an gegenüberliegenden Seiten jeweils eine Leiterschleife 3, 3', die jeweils in Kontakt mit einer Sensorschicht 5, 5' ist.

Die erste Schicht 2 besteht analog zur Ausführungsform aus einer textilen Fläche, in die die Leiterschleifen 3, 3' eingearbeitet sind.

Die Sensorschichten 5, 5' können prinzipiell identisch ausgebildet sein.

Im vorliegenden Fall sind unterschiedliche Sensorschichten 5, 5' vorgesehen, die unterschiedliche Einflussgrößen erfassen. Die erste Sensorschicht 5 kann als leitfähige Schicht ausgebildet sein. Durch eine Auswertung des Stroms in der zugeordneten Leiterschleife 3 kann beispielsweise die Umgebungsfeuchtigkeit ermittelt werden. Die zweite Sensorschicht 5' kann von einer piezoelektrischen Schicht gebildet sein. Durch eine Auswertung des Stroms in der zugeordneten Leiterschleife 3' werden mechanische Belastungen, die auf das Flächenelement 1 einwirken, erfasst.

Bei beiden Ausführungsformen des Flächenelements 1 kann dieses an beiden Seiten mit einer Isolationsschicht abgedeckt sein.

Diese Isolationsschichten sind in den Figuren 1 und 2 nicht dargestellt.

Generell können mehrere Flächenelemente 1 gemäß den Figuren 1 oder 2 zu einer großen durchgehenden Fläche zusammengefügt sein. Dabei sind auch die Enden der Leiterschleifen 3 benachbarter Flächenelemente 1 miteinander verbunden.

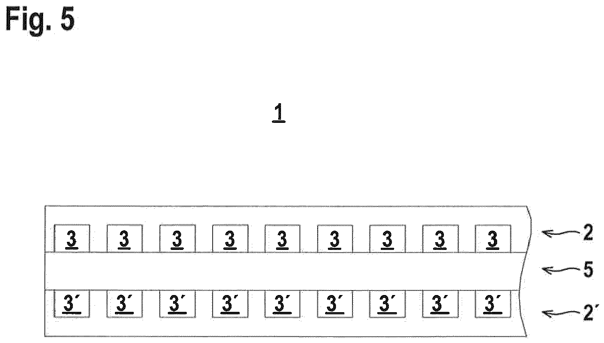

Figur 5 zeigt ein weiteres Ausführungsbeispiel des erfindungsgemäßen Flächenelements 1, wobei dieses im vorliegenden Fall in einem Umkehrbetrieb betrieben wird, so dass mit dessen Sensorschicht 5 definierte Ausgangsgrößen generiert werden können.

Die Sensorschicht 5 liegt zwischen zwei ersten Schichten 2, 2' mit jeweils einer Leiterschleife 3, 3'. Die ersten Schichten 2, 2' bestehen aus textilen Flächen. Die Leiterschleifen 3, 3' können von elektrisch leitfähigen Fäden gebildet sein, die in die textilen Flächen eingearbeitet sind. Die Leiterschleifen 3, 3' können an eine Spannungsquelle wie zum Beispiel eine Batterie angeschlossen werden. Die Leiterschleifen 3, 3' können so ausgelegt werden, dass zwei entgegengesetzt geladene Schichten entstehen.

Die Sensorschicht 5 ist eine elektrisch isolierende Schicht, die prinzipiell in Form einer Folie oder Beschichtung ausgebildet sein kann. Die Sensorschicht 5 ist bevorzugt eine poröse, elektroosmotische Schicht, beispielsweise ein Vlies. Bei Anliegen einer Spannung an die Leiterschleife 3, 3' wird in der Sensorschicht 5 ein elektrisches und/oder magnetisches Feld erzeugt wodurch ein Potenzial für das Flächenelement entstehen kann. Zusammen mit externen Einflussgrößen wie Feuchtigkeit/Wasser und Sauerstoff können so ROS (reactive oxygen species) entstehen, die Viren oder Bakterien schädigen. Dabei können die nötigen Einflussgrößen zur gewünschten elektrochemischen Reaktion in weiteren Ausführungen auch in der Sensorschicht 5 kurz- bzw. langfristig gespeichert werden.

### B ezugszei chenli ste

- (1): Flächenelement
- (2): Schicht, erste
- (3, 3'): Leiterschleife
- (4): Messpunkt
- (5, 5'): Sensorschicht
- (6): Adaptionsschicht

## Patentansprüche

1. Flächenelement (1) mit einer ersten Schicht (2), welche eine in einem isolierenden Material eingebettete Leiterschleife (3) aufweist, und mit einer eine Sensorschicht (5) ausbildenden zweiten Schicht, die in Kontakt mit der Leiterschleife (3) ist, wobei die Sensorschicht (5) zur Erfassung wenigstens einer externen Einflussgröße ausgebildet ist und abhängig von dieser Erfassung ein in der Leiterschleife (3) fließender Strom beeinflusst ist, oder dass das Flächenelement (1) in einem Umkehrbetrieb derart betrieben ist, dass durch Einspeisen von Strömen in die Leiterschleife (3) die oder jede Sensorschicht (5) Ausgangsgrößen generiert.

2. Flächenelement (1) nach Anspruch 1, **dadurch gekennzeichnet, dass** die erste Schicht (2) und die zweite Schicht von einem gemeinsamen Flächensegment oder von zwei separaten Flächensegmenten gebildet sind.

3. Flächenelement (1) nach einem der Ansprüche 1 oder 2, **dadurch gekennzeichnet, dass** die erste Schicht (2) eine textile Fläche ist, wobei die Leiterschleife (3) an der der Sensorschicht (5) zugewandten Seite der ersten Schicht (2) vorgesehen ist.

4. Flächenelement (1) nach Anspruch 3, **dadurch gekennzeichnet, dass** die textile Fläche ein Gewebe, Gestrick, Gewirke oder ein Vlies ist.

5. Flächenelement (1) nach einem der Ansprüche 3 oder 4, **dadurch gekennzeichnet, dass** die Leiterschleife (3) in Form von elektrisch leitfähigen Fäden in die textile Fläche eingearbeitet ist.

6. Flächenelement (1) nach einem der Ansprüche 1 bis 5, **dadurch gekennzeichnet, dass** die Sensorschicht (5) als Beschichtung auf die erste Schicht (2) aufgebracht ist.

7. Flächenelement (1) nach einem der Ansprüche 1 bis 6, **dadurch gekennzeichnet, dass** die Sensorschicht (5) eine leitfähige Schicht oder eine piezoelektrische Schicht ist.

8. Flächenelement (1) nach einem der Ansprüche 1 bis 7, **dadurch gekennzeichnet, dass** die leitfähige Schicht zur Erfassung mechanischer Belastungen und/oder zur Erfassung von Umgebungs-Feuchtigkeit ausgebildet ist.

9. Flächenelement (1) nach einem der Ansprüche 1 bis 8, **dadurch gekennzeichnet, dass** an der zur Sensorschicht (5) gegenüberliegenden Seite der ersten Schicht (2) eine Adaptionsschicht (6) vorgesehen ist, wobei die Adaptionsschicht (6) aus einem isolierenden oder schwach leitfähigen Material besteht.

10. Flächenelement (1) nach einem der Ansprüche 1 bis 8, **dadurch gekennzeichnet, dass** an gegenüberliegenden Seiten der ersten Schicht (2) jeweils eine Leiterschleife (3, 3') vorgesehen ist, wobei jede Leiterschleife (3, 3') in Kontakt mit einer Sensorschicht (5, 5') ist.

11. Flächenelement (1) nach einem der Ansprüche 1 bis 5, **dadurch gekennzeichnet, dass** die Sensorschicht (5, 5') in der Leiterschleife (3, 3') integriert ist.

12. Flächenelement (1) nach Anspruch 11, **dadurch gekennzeichnet, dass** die Leiterschleife (3, 3') in Form von elektrisch leitfähigen Fäden gebildet ist, welche mit Sensorfäden Umwindungen ausbilden, wobei die Sensorfäden die Sensorschicht ausbilden, wobei insbesondere die Sensorfäden von piezoelektrischen Fäden gebildet sind.

13. Flächenelement (1) nach einem der Ansprüche 1 bis 12, **dadurch gekennzeichnet, dass** die Ausgangssignale der oder jeder Leiterschleife (3, 3') ein Maß für externe Einflussgrößen bilden.

14. Flächenelement (1) nach einem der Ansprüche 1 bis 9, **dadurch gekennzeichnet, dass** dieses zwei erste Schichten (2, 2') mit jeweils einer in einem isolierenden Material eingebetteten Leiterschleife (3, 3') aufweist, und dass zwischen den ersten Schichten (2, 2') eine Sensorschicht (5, 5') vorgesehen ist, die im Umkehrbetrieb des Flächenelements (1) Ausgangsgrößen generieren kann.

15. Flächenelement (1) nach Anspruch 14, **dadurch gekennzeichnet, dass** die Sensorschicht (5, 5') eine elektrisch isolierende Schicht ist, in welcher bei einer an den Leiterschleifen (3, 3') anliegenden Spannung reaktive Sauerstoffverbindungen generiert werden.

16. Flächenelement (1) nach Anspruch 15, **dadurch gekennzeichnet, dass** bei an den Leiterschleifen (3, 3') anliegender Spannung elektrische und/oder magnetische Felder generiert werden.

17. Flächenelement (1) nach einem der Ansprüche 14 - 16, **dadurch gekennzeichnet, dass** in der Sensorschicht (5, 5') elektrochemische Prozesse generiert werden, wodurch Einflussgrößen insbesondere in Form von reaktiven Sauerstoffverbindungen entstehen.

18. Flächenelement (1) nach Anspruch 17, **dadurch gekennzeichnet, dass** externe Einflussgrößen in der Sensorschicht (5, 5') für vorgegebene Zeiträume abgespeichert werden.

19. Flächenelement (1) nach Anspruch 14, **dadurch gekennzeichnet, dass** die Sensorschicht (5, 5') eine elektrisch isolierende Schicht ist, in welcher abhängig vom Anliegen einer Spannung an den Leiterschleifen (3, 3') als Ausgangsgröße eine Ionenstruktur in der Sensorschicht (5, 5') geändert wird, wobei je nach Zustand der Ausgangsgröße die Sensorschicht (5, 5') luftdurchlässig oder luftundurchlässig ist.

20. Flächenelement (1) nach einem der Ansprüche 1 bis 9, **dadurch gekennzeichnet, dass** als Ausgangsgrößen Lichtabstrahlungen oder eine Wärmeabgabe vorgesehen sind.
